(19) Europäisches Patentamt / European Patent Office / Office européen des brevets

(11) **EP 2 870 670 B1**

(12) **FASCICULE DE BREVET EUROPEEN**

(45) Date de publication et mention
de la délivrance du brevet:
**01.06.2016  Bulletin 2016/22**

(21) Numéro de dépôt: **13744662.1**

(22) Date de dépôt: **28.06.2013**

(51) Int Cl.:
**H02H 3/33** *(2006.01)*     **G01R 31/02** *(2006.01)*

(86) Numéro de dépôt international:
**PCT/FR2013/051525**

(87) Numéro de publication internationale:
**WO 2014/006308 (09.01.2014 Gazette 2014/02)**

(54) **DISPOSITIF DE PROTECTION DIFFÉRENTIEL.**

DIFFERENZIALSCHUTZVORRICHTUNG

DIFFERENTIAL PROTECTION DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **05.07.2012  FR 1256441**

(43) Date de publication de la demande:
**13.05.2015  Bulletin 2015/20**

(73) Titulaire: **Hager-Electro SAS
67210 Obernai (FR)**

(72) Inventeur: **CHETOUAN, Hichem
F-67380 Lingolsheim (FR)**

(74) Mandataire: **Nuss, Laurent et al
Cabinet Nuss
10 Rue Jacques Kablé
67080 Strasbourg Cedex (FR)**

(56) Documents cités:
**EP-A1- 0 391 812       WO-A1-96/33542
DE-A1-102005 007 378    FR-A1- 2 106 374
FR-A1- 2 502 834**

**Description**

La présente invention concerne un dispositif de protection différentiel permettant par conséquent à titre principal la détection des courants de défaut à la terre. Un tel dispositif trouve sa place notamment dans des appareils électriques de protection de ligne dits DDR pour Dispositif Différentiel à courant Résiduel, comme les interrupteurs ou les disjoncteurs différentiels, utilisés dans des installations électriques domestiques ou tertiaires et qui protègent une arborescence de circuits eux-mêmes distingués par exemple selon le type de charge connectés en aval ou selon les récepteurs raccordés dans le circuit qu'ils protègent.

Ces installations électriques sont alimentées par un réseau électrique alternatif, et le dispositif sur lequel porte l'invention a pour objectif d'assurer principalement la sécurité des tiers en détectant toute fuite vers la terre possible dans un des circuits à protéger, fuite dont il convient de trouver l'origine le plus rapidement possible pour déconnecter ce circuit du réseau électrique et faire ainsi cesser le danger. De telles fuites sont par exemple causées par des contacts directs de tiers avec un conducteur non isolé et des contacts indirects dus à des défauts de masse. Ces incidents électriques sont susceptibles de générer des accidents parfois mortels.

La protection différentielle, dans le contexte précité, s'effectue dans la plupart des cas d'une manière assez standardisée : les conducteurs du circuit à protéger passent dans un tore constitué en matériau ferromagnétique, lesdits conducteurs constituant le primaire du transformateur dont un ou des bobinage(s) constitue(nt) le secondaire. Le tore est - dans une telle configuration - un concentrateur de flux magnétique, et en cas de fuite se traduisant par un déséquilibre des courants d'entrée et de sortie dans les conducteurs des lignes à protéger, le flux créé dans le tore génère dans le bobinage secondaire une tension, utilisée pour commander directement ou à travers une électronique dédiée à un actionneur pouvant être de type relais, lequel actionne à son tour un mécanisme de déclenchement de l'appareil dont il se trouve et/ou ceux d'autres appareils de protection de l'installation. Ce type de protection différentielle est par exemple connu du document WO 96/33542 A1.

Ces appareils électriques de protection différentielle peuvent présenter des caractéristiques variables. Ainsi, ils sont distinguables par leur sensibilité, qui dépend notamment du type d'installation électrique dans laquelle ils sont utilisés. Par ailleurs, certains de ces appareils ne sont capables de détecter des fuites que pour des courants alternatifs alors que d'autres, plus complets, offrent des solutions également applicables au courant continu. C'est le cas du dispositif de protection de l'invention, qui est particulièrement mieux adapté à la détection de fuites constituées de courants continus ou de courants variables comportant une composante continue. Le problème particulier que pose l'existence d'un signal continu est le suivant : il n'y a pas, dans cette hypothèse, de variation du flux dans le tore en matériau ferromagnétique et la tension aux bornes du secondaire est donc nulle. La détection ne peut donc pas se baser sur les conséquences attendues de variations quantifiables de flux magnétique dans le tore.

En revanche, l'existence d'un défaut continu assez élevé au primaire a notamment pour conséquence la saturation du matériau magnétique constituant le tore, caractéristique qui peut dès lors être utilisée dans la détection : c'est sur ce principe que repose la présente invention. A cet égard, le dispositif de l'invention, de sensibilité $I_{DN}$ et qui permet la détection de fuites dans une installation électrique alimentée par au moins un conducteur de phase et, dans certains cas, un conducteur de neutre du réseau, constituant donc le primaire d'un tore en matériau ferromagnétique, comporte de plus un premier enroulement secondaire, bobiné autour dudit tore et raccordé à un générateur de courant ou de tension d'excitation émettant un courant alternatif d'amplitude constante et sans composante continue. Le tore est par ailleurs muni d'un second enroulement secondaire connecté à des étages de traitement des signaux induits par les courants de fuite apparaissant dans les conducteurs primaires et par le courant parcourant le premier enroulement secondaire, étages prévus pour la commande d'un actionneur du type relais prévu pour actionner une serrure mécanique de déclenchement d'un appareil électrique de protection.

Dans cette hypothèse, le tore constitue un circuit magnétique pour les flux magnétiques issus des champs magnétiques rayonnés par les conducteurs primaires d'une part, et produits par le premier enroulement secondaire d'autre part. Celui-ci est parcouru par un courant alternatif sans composante continue, et le domaine de travail du tore, relativement à la courbe B(H) et par conséquent centré autour du point H=B=0 sur la courbe caractéristique correspondante du matériau constituant le tore.

Dans le cas où la somme des courants véhiculés par les conducteurs primaires est nulle, ce qui signifie qu'il n'y a pas de fuite, le flux magnétique dans le tore, résultant de la somme de leurs flux magnétiques respectifs, est également nul. Ainsi, l'unique flux magnétique généré dans le tore est celui qui résulte du premier enroulement secondaire parcouru par le courant alternatif sans composante continue. La tension aux bornes du second enroulement secondaire résulte dès lors uniquement du flux magnétique variable produit par le premier enroulement secondaire.

Dans le cas d'un défaut à la terre, la somme temporelle des courants véhiculés par les conducteurs primaires n'est plus nulle. Le flux magnétique qui résulte des champs magnétiques rayonnés par ces conducteurs primaires dans le tore n'est dès lors plus nul non plus.

Le flux magnétique qui circule dans le tore est à présent la somme de deux flux magnétiques, à savoir celui qui résulte du déséquilibre temporel des courants dans les conducteurs primaires, et celui qui est produit en permanence par le premier enroulement secondaire.

De même, la tension induite au second enroulement secondaire du tore résulte des deux flux précités. L'idée qui est à la base de l'invention est de créer les conditions d'une variation notable du signal dans le second enroulement secondaire, en cas de fuite détectée au niveau des conducteurs primaires, afin de gérer dans de bonnes conditions le déclenchement de l'appareil électrique différentiel.

A cet effet, l'invention se caractérise en ce que :

- le matériau constituant le tore présente une perméabilité $\mu_r$ maximale pour une excitation magnétique H correspondant à un courant de fuite au plus égal à deux fois $I_{DN}$ ;
- la pente de la courbe donnant la perméabilité $\mu_r$ en fonction de H est au moins égale à - 15 m/mA dans la portion descendante de ladite courbe.

Ces caractéristiques reflètent un choix particulier du matériau magnétique du tore, garantissant l'obtention dans le second enroulement secondaire du tore d'une tension dont la valeur moyenne redressée est, en présence d'un défaut à la terre, sensiblement inférieure à celle que l'on obtiendrait en l'absence d'un tel défaut. Plus encore, les caractéristiques ci-dessus signifient que cette tension, qui est notamment redressée par les étages électroniques situés en aval de l'enroulement, décroit significativement en fonction de l'intensité du courant de déséquilibre de défaut des conducteurs primaires.

Concrètement, pour le choix du matériau, la caractéristique B(H) et par conséquent $\mu_r(H)$ est telle que la perméabilité maximale soit en pratique atteinte pour une valeur de champ magnétique H la plus faible possible. En conséquence, un courant de déséquilibre même inférieur à deux fois le courant $I_{DN}$ est suffisant pour décaler le champ de travail du tore dans la zone de saturation de la caractéristique B(H), et par conséquent dans la zone de la caractéristique $\mu_r(H)$ où la perméabilité relative devient non seulement plus faible, puisqu'elle correspond à la saturation magnétique du matériaux constituant le tore, mais encore décroit sensiblement.

Par ailleurs, cela permet de ne pas saturer obligatoirement le matériau magnétique avec le signal d'excitation issu du premier enroulement secondaire, ce qui a pour avantage de réduire significativement la consommation du dispositif. On doit en effet se situer dans la zone de saturation uniquement lorsque le flux de fuite s'additionne au flux créé par le courant alternatif permanent, que l'on qualifiera de courant d'excitation.

La seconde condition précitée sur la pente de la $\mu_r(H)$ indique une perméabilité qui décroit rapidement en fonction de H après l'atteinte de la perméabilité maximale. Or, H constitue l'image du courant de défaut. Cette caractéristique garantit qu'un décalage du champ de travail dans cette zone provoque un décroissement très sensible de la tension moyenne redressée aux bornes du second enroulement secondaire du fait de la décroissance rapide de la perméabilité et par conséquent de la tension aux bornes du second enroulement secondaire.

La perméabilité n'est en effet plus constante, dans le cas où le second enroulement secondaire produit un signal qui dépend à la fois du courant d'excitation dû au premier enroulement secondaire et du courant de défaut continu, car le fonctionnement du tore se décale vers la région saturée de la courbe B(H), où la perméabilité - qui est la pente de cette courbe - varie dans le sens d'une diminution.

D'autres paramètres permettent d'optimiser encore le décroissement de ladite tension, comme par exemple le dimensionnement du tore. Les diamètres intérieur et extérieur de celui-ci ont été ajustés à des valeurs qui permettent de minimiser le courant émis par le générateur à destination du premier enroulement secondaire.

Ainsi, selon l'invention, les dimensions du tore obéissent à la relation suivante :

$$(D_{ext}+D_{int}) \times H(\mu_{rmax}) \leq (4 \times N1 \times I_{DN})/\Pi$$

où $D_{ext}$ est le diamètre extérieur du tore, $D_{int}$ le diamètre intérieur, N1 le nombre de tours primaires, $H(\mu_{max})$ la valeur de l'excitation magnétique pour la perméabilité maximale et $I_{DN}$ la sensibilité du dispositif différentiel.

La matière du tore est bien entendu importante, puisque c'est la sélection de la matière qui permet principalement d'assurer ces caractéristiques.

De préférence, le courant émis par le générateur est de fréquence supérieure à la fréquence du réseau. Comme on l'a déjà mentionné, la saturation du tore par ce courant n'est pas requise. En fait, l'idée est de réduire le courant d'excitation pour réduire la consommation du dispositif tout en essayant d'obtenir par addition des flux dus aux courants d'excitation et de fuite une tension assez élevée en sortie du second enroulement secondaire, de manière à ce que le signal soit exploitable par les étages électroniques placés en aval.

Selon une configuration possible, le générateur de courant émettant un courant d'excitation à l'adresse du premier enroulement secondaire est alimenté par un premier convertisseur AC/DC.

Comme mentionné, un certain nombre d'étages de traitement du signal apparaissant aux bornes du second enroulement secondaire permettent d'obtenir un signal de commande d'un relais capable d'actionner une serrure mécanique. Le dispositif de l'invention est tel que le second enroulement secondaire est en particulier raccordé à au moins un étage amplificateur du signal et/ou à un étage retardateur, en sortie desquels se trouve un étage de comparaison entre une tension de référence et la tension de sortie, puis un étage de commande de puissance pour la commande d'un relais.

En fait, de préférence, l'étage retardateur est un étage convertisseur AC/DC multiplicateur de tension ou un étage redresseur avec une capacité à ses bornes.

Ce convertisseur doit pouvoir générer un retard entre son entrée et sa sortie, retard qui permet en pratique d'avoir une réaction retardée facilitant la gestion des transitoires de type CEM et courants forts équilibrés, ainsi que la gestion des problématiques qui se produisent à la mise sous tension du dispositif.

La tension de référence à l'entrée de l'étage de comparaison est de préférence issue du premier convertisseur AC/DC. Selon une possibilité, un étage retardateur peut au surplus être raccordé entre le premier convertisseur AC/DC et l'étage de comparaison.

Par ailleurs, l'usage d'un étage comparateur, bien adapté à une solution en courant alternatif, l'est moins dans une solution à courant continu : cet étage comparateur peut alors être composé d'un étage soustracteur suivi d'un étage détection de tension à seuil.

L'invention va à présent être décrite au moyen des figures placées en annexe, pour lesquelles :

la figure 1 montre une caractéristique B(H) adaptée au dispositif de l'invention,
la figure 2 représente une caractéristique $\mu_r$(H) qui correspond à la précédente,
les figures 3 et 4 montrent respectivement la caractéristique B(H) et $\mu_r$(H) dans le cas de l'absence d'un courant de fuite,
la figure 5 montre un exemple de courbe de B(t) qu'on peut obtenir sans courant de fuite, avec le courant alternatif $I_{AC}$(t) correspondant,
les figures 6 et 7 montrent les caractéristiques B(H) et $\mu_r$(H) dans le cas de la présence d'un courant de fuite,
la figure 8 montre un exemple de courbe de B(t) qu'on peut obtenir avec courant de fuite $I_{DC}$, lequel apparaît sur la figure ainsi que la somme des courants $I_{DC} + I_{AC}$(t),
la figure 9 illustre schématiquement le dispositif de l'invention en schéma bloc, et
la figure 10 en montre une variante possible.

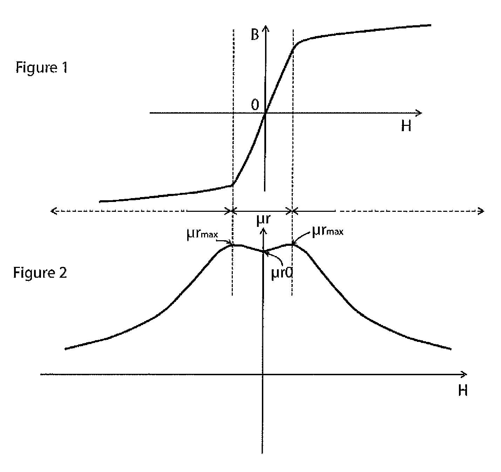

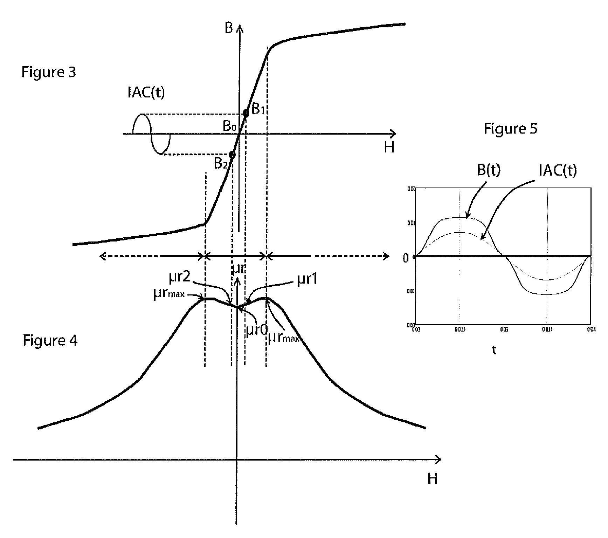

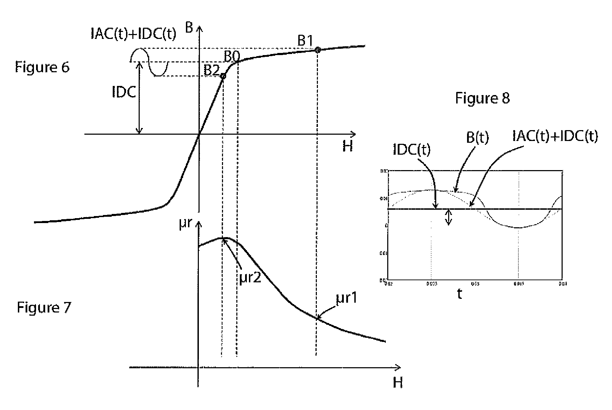

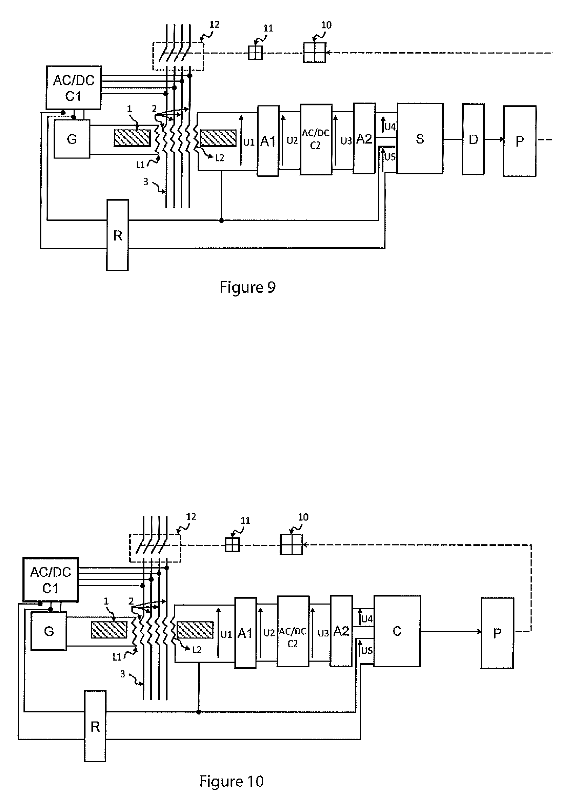

En référence à la figure 1, la caractéristique B(H) idoine pour un tore adapté à un dispositif de protection différentiel selon l'invention est telle qu'en courbe correspondant à la dérivée, une caractéristique $\mu_r$(H) avec des sommets obtenus pour une valeur de H la plus basse possible en valeur absolue, telle que montrée en figure 2, est obtenue. Dès lors que le second enroulement secondaire (L2) apparaissant en figures 9 et 10 n'est plus seulement excité par le courant alternatif d'excitation $I_{AC}$(t) parcourant le premier enroulement secondaire (L1), pour un fonctionnement centré sur B=H=0 dans la caractéristique B(H) tel que montré en figure 3, mais qu'un courant de fuite au primaire apparaît, un décalage de la zone de travail autour d'un point B0 se produit. C'est ce qui apparaît en figure 6.

Dans le premier cas, celui de la figure 3, le point de travail se situe dans la région linéaire de la courbe B(H), d'où une perméabilité $\mu_r$ quasi constante entre $\mu_{r1}$ et $\mu_{r2}$ comme cela apparaît en figure 4, et une tension U2 au secondaire (L2) qui s'exprime de la manière suivante :

$$U2 = -N2 \times \frac{d\emptyset}{dt}$$

$$U2 = -N2 \times \frac{d(B_{AC} \times S)}{dt}$$

$$U2 = -N2 \times S \times \frac{d(B_{AC})}{dt}$$

$$U2 = -N2 \times S \times \mu \frac{d(H_{AC})}{dt}$$

$B_{AC}$ et $H_{AC}$ sont les valeurs de B et H lorsqu'il n'y a qu'un signal d'excitation alternatif AC, en d'autres termes un simple courant d'excitation $I_{AC}(t)$. Dans le cas d'un courant d'excitation $I_{AC}(t)$ et d'un courant de défaut continu $I_{DC}$, comme illustré en figure 6, le point de travail se décale vers la région de saturation non-linéaire de la courbe B(H) et la perméabilité $\mu_r$ n'est plus constante et devient dépendante de H (voir figure 7) qui dépend aussi du courant de défaut continu. La tension U2 s'exprime alors :

$$U2 = -N2 \times \frac{d\emptyset}{dt}$$

$$U2 = -N2 \times \frac{d(Bt \times S)}{dt}$$

$$U2 = -N2 \times S \times \frac{d(Bt)}{dt}$$

$$U2 = -N2 \times S \times \frac{d(\mu(Ht) \times Ht)}{dt}$$

$$U2 = -N2 \times S \times \frac{d(\mu(H_{AC} + H_{DC}) \times (H_{AC} + H_{DC}))}{dt}$$

$B_{DC}$ et $H_{DC}$ sont les valeurs de B et H dues au courant de fuite $_{DC}$. Dans ce dernier cas, le point médian d'oscillation de la perméabilité entre sa valeur min (B2) & max (B1) n'est pas situé à B=0 comme en figure 3, mais à un point B0 supérieur à 0 (ou inférieur à 0 suivant le signe de $H_{DC}$) et c'est ce qui apparaît en figure 6.

Si $H_{DC}$ augmente suffisamment, B0 se déplace en l'occurrence vers la droite de la courbe, ce qui veut dire que le point de fonctionnement du tore se décale vers la région saturée de la courbe de B(H) et, dans cette zone, la perméabilité est moins importante (voir figure 7) et la tension U2 décroit corrélativement.

La figure 8 montre les signaux qui apparaissent, aussi bien pour ce qui concerne les courants créant des flux magnétiques que pour l'induction magnétique qui en résulte, en fonction du temps.

Le dispositif apparaissant aux figures 9 et 10 est constitué à titre principal des éléments suivants :

Une alimentation (C1) permettant une conversion AC/DC de la tension du réseau.

Un tore (1) traversé par les courants (2) des conducteurs de l'installation électrique à protéger : conducteurs de phase (2) et optionnellement un conducteur de neutre.

Le tore (1) est doté d'au moins deux enroulements secondaires L1 et L2.

Un générateur (G) à auto fréquence injectant en permanence un signal (tension ou courant) d'excitation alternatif $I_{AC}(t)$ d'une amplitude fixe et de fréquence supérieure à celle du réseau, via le premier enroulement secondaire (L1). La saturation du tore (1) par le champ d'excitation H produit par la bobine d'excitation (L1) n'est pas nécessaire.

Un second enroulement secondaire (L2) - ou plus - pour mesurer la tension induite par le bobinage d'excitation (L1) et sa variation suite à la présence d'un courant de défaut.

Un étage (C2) permettant une conversion AC/DC de la tension délivrée par le second enroulement secondaire (L2) du tore. Une pré-amplification de cette tension peut être nécessaire pour assurer une conversion optimale, via un premier étage amplificateur (A1). Cet étage (C2) permet aussi, à l'aide de la présence d'au moins une capacité, de créer un retard entre le signal d'entrée (U1 ou U2) issu du second enroulement secondaire (L2) et sa tension de sortie (U3). Un tel retard permet d'avoir une réaction retardée facilitant la gestion des transitoires : CEM et courants forts. Alternativement, le retard peut être produit par un multiplicateur de tension.

Un second étage (optionnel) d'amplification (A2).

Un soustracteur (S) (figure 9) ou comparateur (C) (figure 10) permet de comparer la tension (U4) à une tension de référence (U5).

Un circuit retardateur (R) permet de retarder l'arrivée de la tension de référence au niveau du soustracteur (S) ou du comparateur (C) pour éviter les problématiques qui se produisent suite à la mise sous tension du dispositif.

La sortie du soustracteur (S) peut être reliée à l'entrée d'un détecteur de tension (D). Dans le cas d'utilisation d'un comparateur (C), la sortie peut servir de signal de commande attaquant l'entrée de l'étage de commande (P).

La sortie du détecteur de tension (D) ou celle du comparateur (C) pilote un étage de commande (P) en électronique de puissance, permettant de donner l'ordre à un relais électromécanique (ou un actionneur) (10) de déverrouiller une serrure mécanique (11) et d'ouvrir les contacts (12) placés sur les conducteurs (2) du réseau, ce qui assure la protection des personnes vis-à-vis des lignes concernées.

Les circuits montrés aux figures 9 et 10 ne sont que des exemples possibles, qui peuvent comporter des modifications dont certaines ont été mentionnées (ajout d'un étage amplificateur, différentes possibilités de retardement etc.) sans sortir du cadre de l'invention.

**Revendications**

1. Dispositif de protection différentielle de sensibilité $I_{DN}$ permettant la détection de fuite dans une installation électrique alimentée par au moins un conducteur de phase (2) et, dans certains cas, un conducteur de neutre du réseau, le ou lesdits conducteurs (2) constituant le primaire d'un tore (1) en matériau ferromagnétique muni d'un premier enroulement secondaire (L1) raccordé à un générateur (G) de tension ou de courant émettant un courant d'amplitude constante sans composante continue, et d'un second enroulement secondaire (L2) connecté à des étages de traitement des signaux induits par les courants de fuite répercutés dans les conducteurs primaires (2) et par le courant parcourant le premier enroulement secondaire (L1) en vue de la commande d'un actionneur électromagnétique ou d'un relais (10) prévu pour actionner une serrure mécanique (11), **caractérisé en ce que** :

   - le matériau constituant le tore (1) présente une perméabilité $\mu_r$ maximale pour une excitation magnétique H correspondant à un courant de fuite au plus égal à deux fois $I_{DN}$;
   - la pente de la courbe donnant la perméabilité $\mu_r$ en fonction de H est au moins égale à - 15 m/mA dans la portion descendante de ladite courbe.

2. Dispositif de protection différentielle selon la revendication précédente, **caractérisé en ce que** les dimensions du tore (1) obéissent à la relation suivante :

$$(D_{ext}+D_{int}) \times H(\mu r_{max}) \leq (4 \times N1 \times I_{DN})/\Pi$$

   où $D_{ext}$ est le diamètre extérieur du tore (1), $D_{int}$ le diamètre intérieur, N1 le nombre de tours primaires, $H(\mu r_{max})$ est la valeur de l'excitation magnétique pour la perméabilité maximale et $I_{DN}$ la sensibilité du dispositif différentiel.

3. Dispositif de protection différentielle selon l'une des revendications précédentes, **caractérisé en ce que** le courant émis par le générateur (G) est de fréquence supérieure à la fréquence du réseau.

4. Dispositif de protection différentielle selon la revendication précédente, **caractérisé en ce que** le générateur (G) est alimenté par un premier convertisseur AC/DC (C1).

5. Dispositif de protection différentielle selon l'une quelconque des revendications précédentes, **caractérisé en ce que** le second enroulement secondaire (L2) est raccordé à au moins un étage amplificateur (A1, A2) du signal et/ou à un étage retardateur (C2), en sortie desquels se trouve un étage de comparaison (C) entre une tension de référence (U5) et la tension de sortie (U4), puis un étage de commande de puissance (P) pour la commande d'un relais (10).

6. Dispositif de protection différentielle selon la revendication précédente, **caractérisé en ce que** l'étage retardateur (C2) est un étage convertisseur AC/DC multiplicateur de tension ou un étage redresseur avec une capacité à ses bornes.

7. Dispositif de protection différentielle selon l'une des revendications 5 et 6, **caractérisé en ce que** la tension de référence (U5) est issue du premier convertisseur AC/DC (C1).

8. Dispositif de protection différentielle selon la revendication précédente, **caractérisé en ce qu'**un étage retardateur (R) est raccordé entre le premier convertisseur AC/DC (C1) et l'étage de comparaison (C).

9. Dispositif de protection différentielle selon l'une des revendications 5 à 8, **caractérisé en ce que** l'étage comparateur est composé d'un étage soustracteur (S) suivi d'un étage de détection (D) de tension à seuil.

**Patentansprüche**

1. Differenzialschutzvorrichtung mit einem Schwellenwert $I_{DN}$, die die Leckerkennung in einer elektrischen Anlage ermöglicht, die durch mindestens einen Phasenleiter (2) und in einigen Fällen einen Neutralleiter des Netzes gespeist ist, wobei der oder die Leiter (2) die Primärwicklung eines Ringkerns (1) aus ferromagnetischem Material bilden, der mit einer ersten Sekundärwicklung (L1), die an einen Spannungs- oder Stromgenerator (G) angeschlossen ist, der einen Strom mit konstanter Amplitude ohne Gleichstromkomponente emittiert, und einer zweiten Sekundärwicklung (L2) versehen ist, die mit Verarbeitungsstufen der Signale, die durch die Leckströme, die in die Primärleiter (2) geleitet sind, und durch den Strom, der durch die erste Sekundärwicklung (L1) fließt, induziert sind, verbunden ist, um einen elektromagnetischen Aktuator oder ein Relais (10) zu steuern, der oder das vorgesehen ist, um ein mechanisches Schloss (11) zu betätigen, **dadurch gekennzeichnet, dass**:

   - das Material, das den Ringkern (1) bildet, eine maximale Permeabilität $\mu_r$ für eine magnetische Erregung H aufweist, die einem Leckstrom von höchstens gleich zweimal $I_{DN}$ entspricht;
   - die Steigung der Kurve, die die Permeabilität $\mu_r$ in Abhängigkeit von H gibt, im absteigenden Abschnitt der Kurve mindestens gleich - 15 m/mA ist.

2. Differenzialschutzvorrichtung nach dem vorhergehenden Anspruch, **dadurch gekennzeichnet, dass** die Abmessungen des Ringkerns (1) der folgenden Beziehung genügen:

$$(D_{ext}+D_{int}) \times H(\mu r_{max}) \leq (4 \times N1 \times I_{DN})/\Pi$$

   wobei $D_{ext}$ der Außendurchmesser des Ringkerns (1), $D_{int}$ der Innendurchmesser, N1 die Anzahl von Primärwindungen ist, $H(\mu r_{max})$ der Wert der magnetischen Erregung für die maximale Permeabilität und $I_{DN}$ die Empfindlichkeit der Differentialvorrichtung ist.

3. Differenzialschutzvorrichtung nach einem der vorhergehenden Ansprüche, **dadurch gekennzeichnet, dass** der von dem Generator (G) emittierte Strom von einer Frequenz ist, die höher als die Frequenz des Netzes ist.

4. Differenzialschutzvorrichtung nach dem vorhergehenden Anspruch, **dadurch gekennzeichnet, dass** der Generator (G) von einem ersten AC/DC-Wandler (C1) gespeist ist.

5. Differentialschutzvorrichtung nach einem der vorhergehenden Ansprüche, **dadurch gekennzeichnet, dass** die zweite Sekundärwicklung (L2) mit mindestens einer Verstärkerstufe (A1, A2) des Signals und/oder einer Verzögerungsstufe (C2) verbunden ist, an deren Ausgang sich eine Vergleichsstufe (C) zwischen einer Referenzspannung (U5) und der Ausgangsspannung (U4) und eine Leistungssteuerstufe (P) zum Steuern eines Relais (10) befindet.

6. Differenzialschutzvorrichtung nach dem vorhergehenden Anspruch, **dadurch gekennzeichnet, dass** die Verzögerungsstufe (C2) eine spannungsvervielfachende AC/DC-Wandlerstufe oder eine Gleichrichterstufe mit einer Kapazität an ihren Polen ist.

7. Differenzialschutzvorrichtung nach einem der Ansprüche 5 bis 6, **dadurch gekennzeichnet, dass** die Referenzspannung (U5) aus dem ersten AC/DC-Wandler (C1) hervorgeht.

8. Differenzialschutzvorrichtung nach dem vorhergehenden Anspruch, **dadurch gekennzeichnet, dass** eine Verzögerungsstufe (R) zwischen dem ersten AC/DC-Wandler (C1) und der Vergleichsstufe (C) angeschlossen ist.

9. Differenzialschutzvorrichtung nach einem der Ansprüche 5 bis 8, **dadurch gekennzeichnet, dass** die Vergleichsstufe aus einer Subtrahierstufe (S), gefolgt von einer Erfassungsstufe (D) der Schwellenspannung gebildet ist.

**Claims**

1. Differential protection device with sensitivity $I_{DN}$ allowing the detection of leaks in an electric facility powered by at least one phase conductor (2) and, in some cases, a neutral conductor of the grid, said conductor(s) (2) making up the primary of a toroid (1) made from ferromagnetic material provided with a first secondary winding (L1) connected to a voltage or current generator (G) emitting a current with constant amplitude without a direct component, and a second secondary winding (L2) connected to processing stages for the signals induced by the leak currents appearing in the primary conductors (2) and by the current passing through the first secondary winding (L1) in order to control an electromagnetic actuator or a relay (10) provided to actuate a mechanical lock (11), **characterised in that**:

- the material making up the toroid (1) has a maximum permeability $\mu$r for a magnetic excitation H corresponding to a maximum leak current that is at most equal to twice $I_{DN}$,
- the slope of the curve providing the permeability $\mu$r according to H is at least equal to -15 m/mA in the descending portion of said curve.

2. Differential device according to the preceding claim, **characterised in that** the dimensions of the core (1) obey the following relationship:

$$(D_{ext}+D_{int}) \quad x \quad H(\mu r_{max}) \quad \leq \quad (4xN1xI_{DN})/\Pi$$

where $D_{ext}$ is the outer diameter of the toroid (1), $D_{int}$ is the inner diameter, N1 is the number of primary turns, $H(\mu r_{max})$ is the value of the magnetic excitation for the maximum permeability, and $I_{DN}$ is the sensitivity of the differential device.

3. Differential protection device according to any one of the preceding claims, **characterised in that** the current emitted by the generator (G) has a frequency higher than the frequency of the grid.

4. Differential protection device according to the preceding claim, **characterised in that** the generator (G) is powered by a first AC/DC converter (C1).

5. Differential protection device according to any one of the preceding claims, **characterised in that** the second secondary winding (L2) is connected to at least one amplifier stage (A1, A2) of the signal and/or one time delay stage (C2), at the output of which there is a comparison stage (C) between a reference voltage (U5) and the output voltage (U4), then a power control stage (P) to control a relay (10).

6. Differential protection device according to the preceding claim, **characterised in that** the time delay stage (C2) is a voltage multiplier AC/DC converter stage or a rectifier stage with a capacitance across its terminals.

7. Differential protection device according to one of claims 5 and 6, **characterised in that** the reference voltage (U5) comes from the first AC/DC converter (C1).

8. Differential protection device according to the preceding claim, **characterised in that** a time delay stage (R) is connected between the first AC/DC converter (C1) and the comparison stage (C).

9. Differential protection device according to any one of claims 5 to 8, **characterised in that** the comparator stage is made up of a subtracter stage (S) followed by a threshold voltage detection stage (D).

Figure 1

Figure 2

EP 2 870 670 B1

Figure 3

Figure 4

Figure 5

Figure 6

Figure 7

Figure 8

Figure 9

Figure 10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9633542 A1